# EUROPEAN PATENT SPECIFICATION

(11) **EP 0 257 347 B1**
(45) Date of publication and mention of the grant of the patent: **17.03.1993**
(21) Application number: 87111119.1
(22) Date of filing: 31.07.1987
(51) Int. Cl.: H01L 27/04

(54) **Semiconductor device equipped with a trench capacitor for preventing circuit misoperation**
Halbleitervorrichtung dass ein Kondensatorgraben zur Verhütung von Schaltungsfehlern umfasst
Arrangement de semi-conducteur equipé d'un condensateur à tranchée pour empêcher le mauvais fonctionnement d'un circuit

(30) Priority: 31.07.1986 JP 178839/86
(43) Date of publication of application: 02.03.1988
(73) Proprietor: NEC CORPORATION, Tokyo (JP)
(72) Inventor: Tamakoshi, Akira c/o NEC Corporation, Minato-ku Tokyo (JP); Kawata, Kouji c/o NEC Corporation, Minato-ku Tokyo (JP)
(74) Representative: Glawe, Delfs, Moll & Partner

(56) References cited:
- EP-A- 0 169 559
- IEEE ELECTRON DEVICE LETTERS, vol. EDL-3, no. 7, July 1982, pages 182-184, New York, US; H. OTSUKA et al.: "The effect of substrate materials on holding time degradation in MOS dynamic RAM"
- PATENT ABSTRACTS OF JAPAN, vol. 6, no. 247 (E-146)[1125], 7th December 1982; & JP - A - 57 147 280

## Description

### BACKGROUND OF THE INVENTION

The present invention relates to a semiconductor device and particularly to a semiconductor integrated circuit device comprising MOS (Metal-Oxide-Semiconductor) transistors (called hereinafter "MOS-IC").

As well known in the art of MOS-IC, a protective circuit is provided between an input terminal and an input transistor to prevent destruction of a gate insulating film of the input transistor, and it includes a protective region electrically connected to the input terminal. The protective region forms a PN junction with a semiconductor substrate in which the input transistor and other transistors including an output transistor are fabricated. The output transistor has source and drain regions, one of which is electrically connected to an output terminal, to output a signal to the output terminal. The source and drain regions form a PN junction with the semiconductor substrate. Thus, each of the input and output terminals is connected with a semiconductor region forming a PN junction with the semiconductor substrate. Such a device is known from EP-A-0 169 559.

In operation, each of the input and output terminals is often applied with such a surge or noise voltage that forward-biases the PN junction or reverse-biases it to cause the primary breakdown. As a result, carriers are injected from the semiconductor region into the semiconductor substrate and flows therethrough. The flow of the carries in the substrate raises the potential of the substrate to change the threshold voltage of the respective transistors, or destroys data stored in memory cells or flip-flops. The circuit misoperation of the device thereby occurs.

### SUMMARY OF THE INVENTION

Accordingly, an object of the present invention is to provide a semiconductor device having an improvided device structure as defined in claim 1.

Another object of the present invention is to provide an MOS-IC equipped with misoperation-preventing means against a surge or noise voltage applied to a terminal.

A device according to the present invention comprises a semiconductor substrate of one conductivity type, a terminal formed on an insulating film covering the semiconductor substrate, a semiconductor region of an opposite conductivity type formed in the semiconductor substrate and electrically connected to the terminal, and a trench capacitor formed in the semiconductor substrate and surrounding in a plan view the semiconductor region, the trench capacitor having two electrodes, one electrode being the semiconductor substrate and the other electode being in a trench and being applied with such a voltage that provides an inversion layer or a space charge region (depletion layer) in the semiconductor substrate around said trench.

When a surge or noise voltage happens to be applied to the terminal carriers are injected into the substrate from the semiconductor region and the injected carriers intend to flow through the substrate. However, the inversion layer or the space charge region traps the injected carries to prevent them from flowing through the substrate. Thus, the carries does not reach an internal portion of the substrate wherein input and output transistors and other transistors are formed to constitute a transistor circuit. The circuit misoperation thereby does not occur.

### BRIEF DESCRIPTION OF THE DRAWINGS

The above and other objects, advantages and features of the present invention will be more apparent from the following description taken in conjunction with the accompanying drawings, in which:
Fig. 1 is a plan view of a semiconductor device according to a first embodiment of the present invention;
Fig. 2 is a cross sectional view along a line A-Aʹ of the device shown in Fig. 1;
Fig. 3 is a plan view of a semiconductor device according to a second embodiment of the present invention; and
Fig. 4 is a plan view of a semiconductor device according to a third em bodiment of the present invention.

### DETAILED DESCRIPTION OF THE PREFERRED EMBODIMENTS

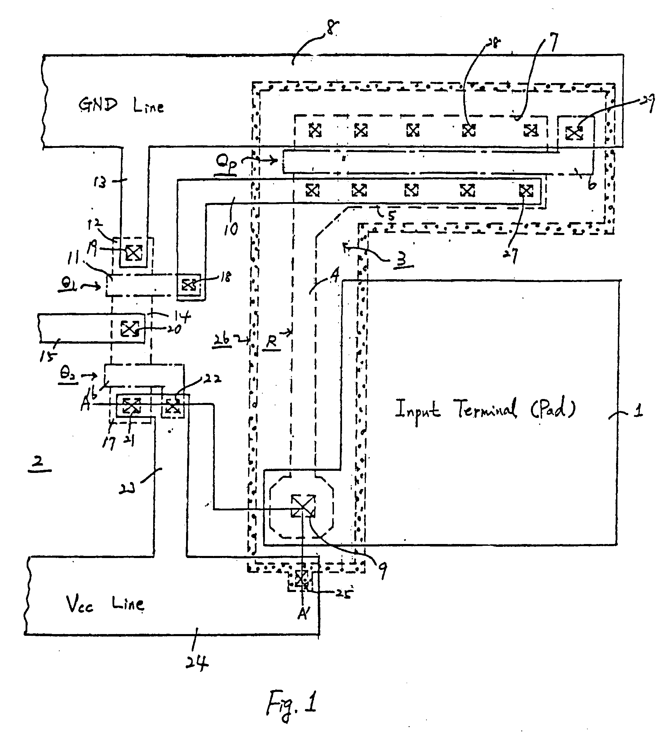

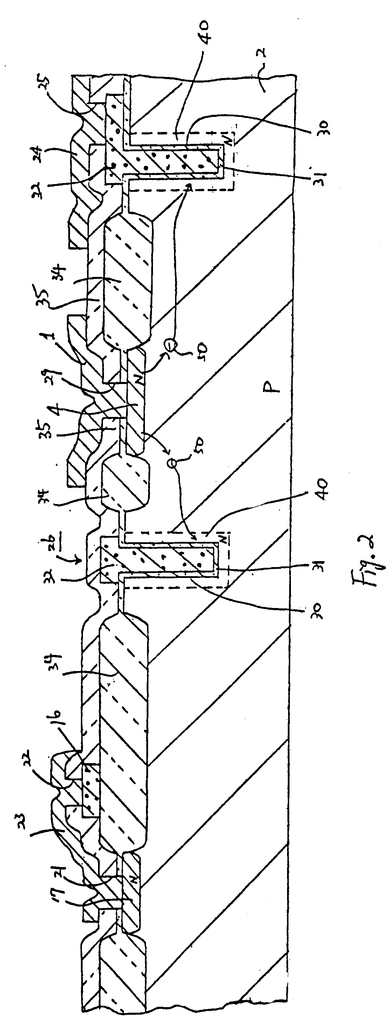

Referring to Figs. 1 and 2, a first embodiment of the present invention includes an input terminal (or pad) 1 formed on an insulating film 34 covering a silicon substrate 2 of one conductivity type (a P-type in this embodiment). The input terminal 1 is made of aluminum and is supplied with a data or control signal from an externally provided signal source (not shown). The data or control signal is supplied to a gate electrode 11 of an input transistor Q₁ through a protective circuit 3 which comprises a protective resistor R and a protective transistor Q_{P}. The protective resistor R is comprised of an elongated resistor region 4 of the opposite conductivity type (i.e., an N-type) formed in the substrate 1. The one end portion of the resistor region 4 is electrically connected with the input terminal 1 which is in contact thereto through a contact hole 9 provided in an insulating film 35 made of silicon dioxide, and the other end portion thereof is connected to a source region 5 of the protective transistor Q_{P}. The source region 5 is of the opposite conductivity type and formed integrally with the resistor region 4. An interconnection line 10 made of aluminum is connected through a plurality of contact holes 27 to the source region 5 and also connected to the gate electrode 11 of the input transistor Q₁ made of polycrystalline silicon through a contact hole 18. The protective transistor Q_{P} has its gate electrode 6 made of polycrystalline silicon and a drain region 7 of the N-type, which are connected in common to a ground line 8 made of aluminum through a contact hole 29 and a plurality of contact holes 28, respectively. The input transistor Q₁ has a source region 12 of the N-type connected via a contact hole 19 to a branch line 13 of the ground line 8 and a drain region 14 of the N-type connected to an output line 15. The region 14 also functions as a source region of a load transistor Q₂ which has a gate electrode 16 made of polycrystalline silicon and a drain region 17 of the N-type, both being connected via respective contact holes 22 and 21 to an interconnection line 23 extended from a power (V_{cc}) line 24 applied with a positive power voltage of 5 V, for example. The input transistor Q₁ and the load transistor Q₂ constitute an inverter circuit of an input buffer.

If the discharging of static electricity occurs at the input terminal 1, the protective circuit 3 restricts a peak voltage caused by such discharging, as well known in the art, to thereby protect the gate of the input transistor Q₁.

In operation, the data or control signal supplied to the input terminal 1 is inverted by the inverter comprised of the transistors Q₁ and Q₂, and the inverted signal is supplied via the interconnection line 15 to an internal circuit (not shown) formed on the substrate 1. However, the input terminal 1 is often applied with a surge or noise voltage during a normal operation period. The surge or noise voltage reverse-biases a PN junction formed between the resistor region 4 and the substrate 1 to cause the primary breakdown thereof or forward-biases that PN junction. In both cases, carriers (electrons in this embodiment) are injected from the resistor region 4 into the substrate 1. The injected carriers flow through the substrate 1 as a substrate current to raise a substrate potential. The threshold voltages of transistors including the transistors Q₁ and Q₂ are thereby changed to cause a circuit misoperation. If the injected carriers reach a memory cell (not shown), they destroy data in the memory cell. Moreover, if the injected carriers reach the region 17 connected to the V_{cc} line 24, a parasitic bipolar transistor is turned on, which is comprised of the N-type resistor region 4, a portion of the P-type substrate and the N-type region 17, to allow a relatively large current to flow into the region 17. As a result, the PN junction formed between the region 17 and the substrated 1 is destroyed.

In order to solve such drawbacks, a trench capacitor 26 in accordance with the present invention is provided in the substrate 1 to surround the resistor region 4 and the source and drain regions 5 and 7 of the protective transistor Q_{P} in this embodiment. As shown in Fig. 2, the trench capacitor 26 has a trench 30 formed in the substrate 1 along the resistor region 4 and the source and drain regions 5 and 7 to completely surround them. The trench 30 is formed deeper than the junction depth of the regions 4, 5 and 7. The inner surface of the trench 30 is covered with a silicon dioxide film 31 and a polycrystalline silicon layer 32 which fills the trench 30. The polycrystalline silicon layer 32 is highly doped with impurities such as phosphorus to thereby operate as a conductive layer and is applied with such a fixed voltage that provides an inversion layer or a space charge region (depletion layer) in the substrate 1 around the trench 30. In this embodiment, the polycrystalline silicon layer 32 is connected to the V_{cc} line 24 through a contact hole 25 formed in the silicon dioxide layer 35 to receive the power voltage. An inversion layer 40 is thereby formed in the substrate 1 around the trench capacitor 26. Accordingly, as shown in Fig. 2, the electrons 50 injected from the resistor region 4 into the substrate 1 due to the application of the surge or noise voltage to the input terminal 1 are trapped by the inversion layer 40 to be prevented from reaching the input buffer of the transistors Q₁ and Q₂ as well as the internal circuit. Thus, the above-mentioned misoperation and the data destruction do not occur.

Since the P-type substrate 2 is biased with a negative voltage or a ground voltage, the ground voltage or an intermediate voltage between the ground and power voltages may be supplied to the polycrystalline silicon layer 32 in place of the power voltage V_{cc}. In this case, the space charge region (depletion layer) is formed in the substrate 1 around the trench 30 and traps the injected carriers 50.

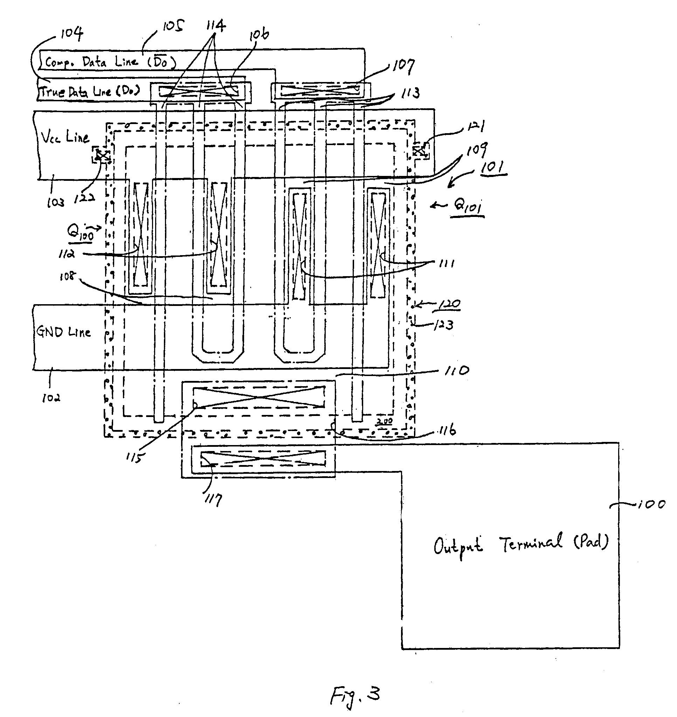

With reference to Fig. 3, a second embodiment of the present invention comprises a signal output stage 101. This output stage 101 includes two output transistors Q₁₀₀ and Q₁₀₁ connected in series between a power supply (V_{cc}) line 103 and a ground (GND) line 102 and receiving true and complementary data signals D₀ and D̅₀̅, respectively, and an output data signal therefrom appears on an output terminal (pad) 100, which is in turn supplied to an externally provided device (not shown). The first and second output transistors Q₁₀₀ and Q₁₀₁ are of an N-channel type and formed in a P-type silicon substrate 200. The transistor Q₁₀₀ has two N-type drain regions 108 connected via contact holes 112 to the V _{cc} line 103, gate electrodes 114 made of polycrystalline silicon and connected via a contact hole 106 to a true data supply line 104, and an N-type source region 110 connected via a contact hole 115 to a polycrystalline silicon layer 116 doped with impurities. The layer 116 is connected via a contact hole 117 to the output terminal 100. The region 110 also functions as a drain region of the second output transistor Q₁₀₁ which has two N-type source regions 109 connected via contact holes 111 to the ground line 102 and gate electrodes 113 connected via a contact hole 107 to a complementary data supply line 105.

In operation, an internal circuit (not shown) produces true and complementary data signals D₀ and D̅₀̅ on the lines 104 and 105, respectively, so that one of the output transistors Q₁₀₀ and Q₁₀₁ is turned ON. As a result, the high level or low level data signal appears on the output terminal 100.

However, a surge or noise voltage happens to be applied from the outside of the device to the output terminal 100, so that carriers are injected from the region 110 to the substrate 200.

In order to prevent the injected carriers from reaching the internal circuit, a trench capacitor 120 is provided in the substrate 200 to surround the output transistors Q₁₀₀ and Q₁₀₁. The trench capacitor 120 has the same structor as the trench capacitor 26 shown in Figs. 1 and 2, and therefore the cross-sectional view of the device of Fig. 3 is omitted. A polycrystalline silicon layer 123 filling a trench of the trench capacitor 120 is connected through contact holes 121 and 122 to the V_{cc} line 103, so that an inversion layer (not shown) is formed in the substrate 200 around the trench capacitor 120. This inversion layer traps the carriers injected from the region 110 into the substrate due to the application of the surge or noise voltage to the output terminal 100 to prevent them from reaching the internal circuit.

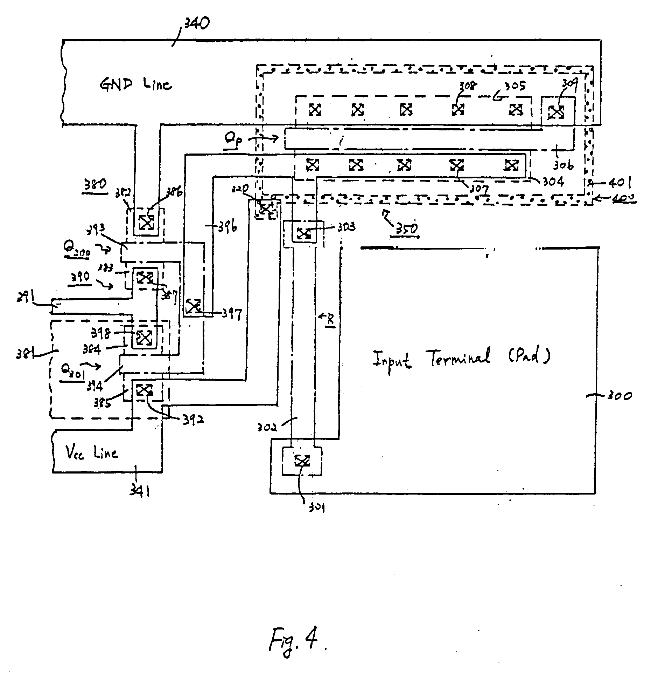

Referring to Fig. 4, a third embodiment of the present invention comprises an input stage 390 of a complementary MOS-IC. This input stage 390 has an N-channel transistor Q₃₀₀ and a P-channel transistor Q₃₀₁. The transistor Q₃₀₀ has an N-type source region 382 connected via a contact hole 386 to a ground line 340, an N-type drain region 383 connected via a contact hole 387 to an output line 391, and a gate electrode 393 connected to a gate electrode 394 of the transistor Q₃₀₁ which has a P-type source region 385 connected via a contact hole 392 to a power supply (V_{cc}) line 341 and a P-type drain region 384 connected through a contact hole 398 to the output line 391. The N-type regions 382 and 383 are formed in a P-type silicon substrate 380 and the P-type regions 384 and 385 are formed in an N-type well region 387 provided in the substrate 380. A protective circuit 350 is provided between the input stage 390 and an input terminal (Pad) 300 and comprises a protective resistor R and a protective transistor Q_{P}. The resistor R is composed of a polycrystalline layer 302 formed on an insulating film covering the substrate 380, one end portion of which is connected to the input terminal 300 through a contact hole 301. The other end portion of the resistor R (302) is connected via a contact hole 303 to an interconnection line 396 which is in turn connected to the gate electrodes 393 and 394 of the transistors Q₃₀₀ and Q₃₀₁ and to an N-type source region 304 of the protective transistor Q_{P} through contact holes 307. The transistor Q_{P} has an N-type drain region 305 and a gate electrode 306 which are connected in common to the ground line 340 through contact holes 308 and 309, respectively.

In accordance with the present invention, a trench capacitor 400 is formed in the substrate along the regions 304 and 305 to completely surround them. The trench capacitor 400 has the same structure as the trench capacitor 26 shown in Figs. 1 and 2. A polycrystalline silicon layer 401 as a conductive layer filling a trench of the trench capacitor 400 is connected through a contact hole 320 to the V_{cc} line 341. As a result, an inversion layer (not shown) is formed in the substrate 380 around the trench capacitor 400 to trap carriers injected from the region 304 into the substrate 380 due to the application of a surge or noise voltage to the input terminal 300. The injected carriers are thereby prevented from reaching a transistor formation portion including the transistors Q₃₀₀ and Q₃₀₁.

The present invention is not limited to the above-mentioned embodiments, but is defined by the claims. For example, the conductivity types of the substrate and the respective regions can be changed, and in that case a ground voltage is favorably supplied to the conductive layer of the trench capacitor. In the case where the semicon ductor device includes a plurality of dynamic memory cells each comprises a field effect transistor as a transfer gate and a trench capacitor as a storage capacitor, each trench capacitor for memory cells and the trench capacitor 26 (120, 400) are formed simultaneously.

## Claims

1. A semiconductor device comprising a semiconductor substrate (2) of one conductivity type, a terminal (1, 100, 300) formed on an insulating film (34) covering said semiconductor substrate, and a semiconductor region (4, 5, 7, 108-110, 304, 305) of an opposite conductivity type formed in said semiconductor substrate and electrically connected to said terminal,
**characterized** by further comprising a trench capacitor (26, 120, 400) formed to surround said semiconductor region (4, 5, 7, 108-110, 304, 305) and having two electrodes, one electrode being said semiconductor substrate (2) and the other electrode (32, 123, 401) being in a trench (30) and being applied with such a voltage that provides an inversion layer or a space charge layer (40) around said trench.

2. The device as claimed in claim 1, further comprising an input transistor (Q1, Q2, Q300, Q301) and a protective circuit (3, 350) provided between said terminal and said input transistor, said semiconductor region (4, 5, 7, 304, 305) constituting a part of said protective circuit.

3. The device as claimed in claim 2, wherein said protective circuit includes a resistor (R) and a protective transistor (Qp) and said semiconductor region (5, 7, 304, 305) is employed as said resistor.

4. The device as claimed in claim 2, wherein said protective circuit includes a resistor (R) and a protective transistor (Qp) and said semiconductor region (4) is employed as a source/drain region of said protective transistor.

5. The device as claimed in claim 1 , **characterized** by further comprising an output transistor (Q100, Q101) having a source/drain region formed by said semiconductor region (108-110).

## Patentansprüche

1. Halbleitervorrichtung mit einem Substrat (2) mit einem Leitfähigkeitstyp, einem Anschluß (1, 100, 300), der auf einem isolierenden Film (34) ausgebildet ist, welcher das Halbleitersubstrat bedeckt, und einem Halbleiterbereich (4, 5, 7, 108 bis 110, 304, 305) mit einem entgegengesetzten Leitfähigkeitstyp, der in dem Halbleitersubstrat ausgebildet und elektrisch mit dem Anschluß verbunden ist, dadurch **gekennzeichnet,** daß er ferner aufweist einen Kondensatorgraben (26, 120, 400), der so ausgebildet ist, daß er den Halbleiterbereich (4, 5, 7, 108 bis 110, 304, 305) umgibt und der zwei Elektroden aufweist, von denen eine das Halbleitersubstrat (2) ist und die andere (32, 123, 401) in einem Graben (30) liegt und mit solch einer Spannung beaufschlagt wird, daß sie um den Graben eine Inversionsschicht oder eine Raumladungsschicht (40) schafft.

2. Vorrichtung nach Anspruch 1, dadurch **gekennzeichnet,** daß sie ferner aufweist einen Eingangstransistor (Q₁, Q₂, Q₃₀₀, Q₃₀₁) und eine Schutzschaltung (3, 350), die zwischen dem Anschluß und dem Eingangstransitor angeordnet ist, wobei der Halbleiterbereich (4, 5, 7, 304, 305) einen Teil der Schutzschaltung bildet.

3. Vorrichtung nach Anspruch 2, dadurch **gekennzeichnet,** daß die Schutzschaltung einen Widerstand (R) enthält und einen Schutztransistor (Qₚ) und daß der Halbleiterbereich (5, 7, 304, 305) als der Widerstand verwendet wird.

4. Vorrichtung nach Anspruch 2, dadurch **gekennzeichnet,** daß die Schutzschaltung einen Widerstand (R) und einen Schutztransistor (Qₚ) enthält und daß der Halbleiterbereich als Source-Drain-Bereich des Schutztransistors verwendet wird.

5. Vorrichtung nach Anspruch 1, dadurch **gekennzeichnet,** daß sie ferner enthält einen Ausgangstransistor (Q₁₀₀, Q₁₀₁), dessen Source-Drain-Bereich durch den Halbleiterbereich (108 bis 110) gebildet wird.

## Revendications

1. Dispositif semi-conducteur comprenant un substrat semi-conducteur (2) d'un premier type de conductivité, une borne (1, 100, 300) formée sur un film isolant (34) recouvrant le substrat semi-conducteur, et une région semi-conductrice (4, 5, 7, 108 à 110, 304, 305) d'un type de conductivité opposé formée dans le substrat semi-conducteur et électriquement connectée à la borne,
caractérisé en ce qu'il comprend de plus un condensateur en tranchée (26, 120, 400) formé pour entourer la région semi-conductrice (4, 5, 7, 108 à 110, 304, 305) et comportant deux électrodes, une électrode étant le substrat semi-conducteur (2) et l'autre électrode (32, 123, 401) étant dans une tranchée (30) et recevant une tension telle qu'elle procure une couche d'inversion ou une couche de charge d'espace (40) autour de la tranchée.

2. Dispositif selon la revendication 1, comprenant de plus un transistor d'entrée (Q₁, Q₂, Q₃₀₀, Q₃₀₁) et un circuit de protection (3, 350) prévu entre la borne et le transistor d'entrée, la région semi-conductrice (4, 5, 7, 304, 305) constituant une partie du circuit de protection.

3. Dispositif selon la revendication 2, dans lequel le circuit de protection comporte une résistance (R) et un transistor de protection (Qₚ) et la région semi-conductrice (5, 7, 304, 305) est utilisée en tant que résistance.

4. Dispositif selon la revendication 2, dans lequel le circuit de protection comporte une résistance (R) et un transistor de protection (Qₚ) et la région semi-conductrice (4) est employée comme région de source/drain du transistor de protection.

5. Dispositif selon la revendication 1, caractérisé de plus en ce qu'il comprend un transistor de sortie (Q₁₀₀, Q₁₀₁) ayant une région de source/drain formée par la région semi-conductrice (108 à 110).
